# EUROPÄISCHE PATENTANMELDUNG

(11) **EP 2 506 696 A2**
(43) Veröffentlichungstag der Anmeldung: **03.10.2012**
(21) Anmeldenummer: 12002267.8
(22) Anmeldetag: 29.03.2012
(51) Int. Cl.: H05K 7/20

(54) **Selbsttragendes Kühlmodul**

(30) Priorität: 01.04.2011 DE 102011015859
(71) Anmelder: Rittal GmbH & Co. KG, 35745 Herborn (DE)
(72) Erfinder: Knetsch, Jörg Christian, 35630 Ehringshausen (DE); Marangoni, Giovanni, 37068 Vigasio Verona (IT); Bonetti, Sebastiano, 37024 San Vito di Negrar Verona (IT)
(74) Vertreter: Tönhardt, Marion

(57) **Zusammenfassung**

Ein selbsttragendes Kühlmodul, bestehend aus einem selbsttragenden Kühlmodulkörper (102, 104), der aus geschäumtem Kunststoffmaterial aufgebaut ist, wobei in dem Kühlmodulkörper (102, 104) eine Referenzebene (A) definiert ist, in Bezug auf die in dem Kühlmodulkörper (102, 104) befindliche Komponenten in einer ersten Betriebsposition, in der alle Komponenten betriebsfähig zusammenwirken, angeordnet sind, einer Vielzahl von Komponenten (106, 108, 300), die zu kühlen sind oder die eine Kühlfunktion ausüben, wobei die Komponenten, die eine Kühlfunktion ausüben, zumindest einen Wärmetauscher (106) umfassen, ist dadurch gekennzeichnet, dass die Komponenten (106, 108, 300) so in den Kühlmodulkörper (102, 104) eingelassen sind, dass sie auch in einer zweiten Betriebsposition, die gegenüber der ersten Betriebsposition um eine in der Referenzebene (A) liegende Achse um 180° gedreht ist, betriebsfähig zusammenwirken.

## Beschreibung

Die Erfindung betrifft ein selbsttragendes Kühlmodul, bestehend aus einem selbsttragenden Kühlmodulkörper, der aus geschäumtem Kunststoffmaterial aufgebaut ist, wobei in dem Kühlmodulkörper eine Referenzebene definiert ist, in Bezug auf die in dem Kühlmodulkörper befindlichen Komponenten in einer ersten Betriebsposition, in der alle Komponenten betriebsfähig zusammenwirken, angeordnet sind, und mit einer Vielzahl von Komponenten, die zu kühlen sind oder die eine Kühlfunktion ausüben, wobei die Komponenten, die eine Kühlfunktion ausüben, zumindest einen Wärmetauscher umfassen.

Ein derartiges selbsttragendes Kühlmodul ist aus der DE 10 2004 032 920 A1 bekannt. Als geschäumtes Kunststoffmaterial wird expandierendes Polypropylen (EPP) vorgeschlagen, das hervorragende Festigkeitseigenschaften aufweist, so dass es die Komponenten zuverlässig halten kann. Der Kühlmodulkörper besteht aus zwei miteinander zusammenwirkenden Schalen, zwischen denen die Komponenten angeordnet werden, wobei die Schalen dies in der gewünschten Funktionsstellung fixieren. Es ist weiter vorgesehen, in der unteren der beiden Schalen eine Kondensatwanne auszubilden, in der sich Feuchtigkeit sammeln kann, die sich möglicherweise an diversen Komponenten des Kühlmoduls niederschlägt.

Ein ähnliches Kühlmodul ist in der EP 0 546 211 B2 beschrieben, das ebenfalls einen zweischaligen Kühlmodulkörper aus expandiertem Polypropylen verwendet. Dieses Kühlmodul soll in einem optischen Gerät oder in einem Gerät für die analytische Chemie, beispielsweise einem Flüssigkeitschromatografen, eingesetzt werden.

Es ist die Aufgabe der vorliegenden Erfindung, ein selbsttragendes Kühlmodul zur Verfügung zu stellen, das flexibel in verschiedenen Einbausituationen eingesetzt werden kann und das dabei seine volle Funktionalität entfaltet. Insbesondere soll es auch bei rauen Betriebsbedingungen zuverlässig arbeiten.

Diese Aufgabe wird von einem selbsttragenden Kühlmodul nach Anspruch 1 gelöst. Vorteilhafte Ausgestaltungen sind Gegenstand der Unteransprüche.

Erfindungsgemäß ist bei einem selbsttragenden Kühlmodul der eingangs genannten Gattung vorgesehen, dass die Komponenten so in den Kühlmodulkörper eingelassen sind, dass sie auch in einer zweiten Betriebsposition, die gegenüber der ersten Betriebsposition um eine in der Referenzebene liegende Achse um 180° gedreht ist, betriebsfähig zusammenwirken.

Nach einer bevorzugten Ausführungsform der Erfindung ist der Kühlmodulkörper zweischalig ausgebildet, wobei die Grenzfläche der zwei Schalen parallel zu oder in der Referenzebene liegt.

Weiter vorteilhaft weist der Wärmetauscher einen Kondensatablauf auf, der in der ersten Betriebsposition Kondensat in einer ersten Richtung entlässt und der in der zweiten Betriebsposition Kondensat in einer zweiten Richtung entlässt. Es braucht also, wenn das Kühlmodul in seiner um 180° gedrehten Betriebsposition eingebaut werden soll, nur der entsprechende Kondensatablauf verschlossen zu werden, damit das Gerät wieder funktionsfähig ist und betriebssicher arbeitet.

Vorteilhaft ist dabei der Kondensatablauf ein Zwei-Wege-Ablauf, der insbesondere ventilgesteuert ausgebildet sein kann.

Es ist zweckmäßig, eine Steuerung vorzusehen, welche die eine Kühlfunktion ausübenden Komponenten abhängig von Signalen, die von mindestens einem Temperatursensor und/oder von mindestens einem Feuchtesensor an die Steuerung ausgegeben werden, betreibt.

Bei Vorhandensein einer derartigen Steuerung ist es auch sinnvoll, einen Lagesensor vorzusehen, wobei die Steuerung abhängig von den von dem Lagesensor empfangenen Signalen das Ventil des Zwei-Wege-Ablaufs steuert, um das Kondensat entsprechend der erfassten Position des Kühlmodulkörpers in die erste Richtung oder in die zweite Richtung zu entlassen.

Als Kunststoffmaterial für das erfindungsgemäße Kühlmodul soll expandiertes Polypropylen verwendet werden.

Ebenso vorteilhaft werden die Schalen des Kühlmodulkörpers in der montierten Position ineinander verrastet, so dass keine zusätzlichen Fixiereinrichtungen, wie z. B. Haltebänder, nötig sind.

Im folgenden soll die Erfindung anhand der beigefügten Zeichnung näher erläutert werden. Es zeigt:
- Figur 1: ein Kühlmodul gemäß der vorliegenden Erfindung in Sockelmontage in einem Chassis,
- Figur 2: eine Schnittansicht der Anordnung gemäß Figur 1;
- Figur 3: eine perspektivische Ansicht des Kühlmodulkörpers mit darin angeordneten Komponenten;
- Figur 4: ein Kühlmodul gemäß der vorliegenden Erfindung in Deckenmontage in einem Chassis;
- Figur 5: eine Schnittansicht der Anordnung gemäß Figur 4;
- Figur 6: eine perspektivische Ansicht des Kühlmodulkörpers mit darin angeordneten Komponenten;
- Figur 7: eine Gesamtansicht des selbsttragenden Kühlmoduls gemäß der vorliegenden Erfindung in einer Explosionsdarstellung; und
- Figur 8: ein stark schematisiertes Schaltbild zur Steuerung des Kühlmoduls gemäß der vorliegenden Erfindung.

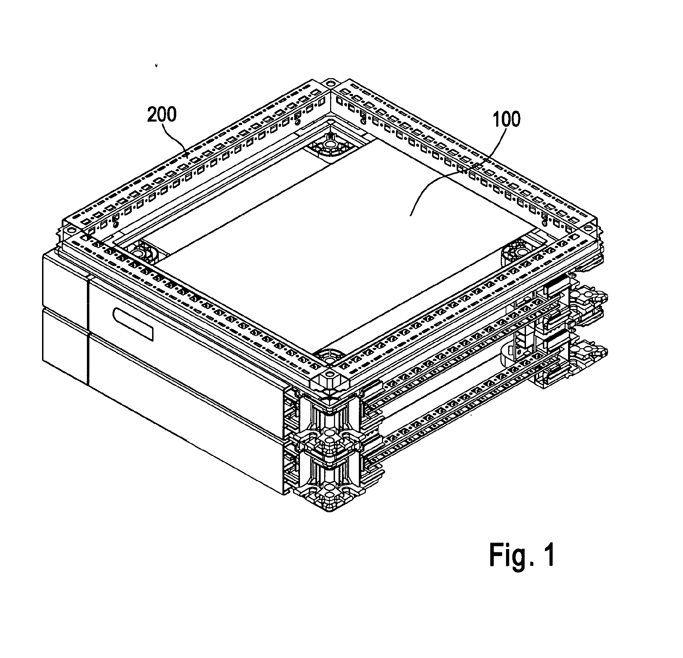

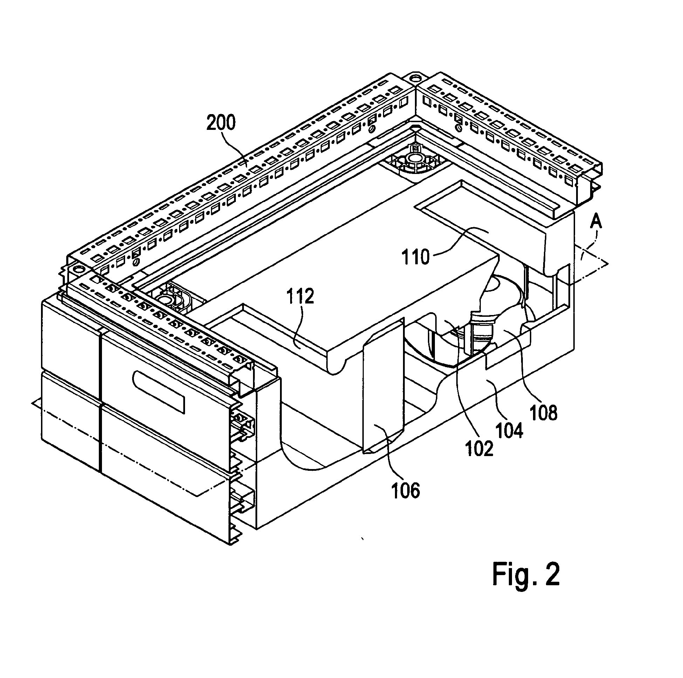

Figur 1 zeigt ein selbsttragendes Kühlmodul 100 gemäß einer Ausführungsform der vorliegenden Erfindung in einer ersten Betriebsposition in Sockelmontage in einem Chassis 200. Einzelheiten des Kühlmoduls 100 sind besser in der Schnittansicht gemäß Figur 2 zu erkennen. Das Kühlmodul 100 weist einen Kühlmodulkörper auf, der aus zwei Schalen 102, 104 gebildet ist, die in einer Referenzebene A zusammengefügt sind, beispielsweise über Rastverbindungen, so dass keine zusätzlichen Fixiereinrichtungen nötig sind. In entsprechenden Ausnehmungen, die in den Schalen 102, 104 gebildet sind, sind die Komponenten des Kühlmoduls gemäß der vorliegenden Erfindung angeordnet, beispielsweise ein Wärmetauscher 106 und ein Lüfter 108, der als Radiallüfter ausgebildet sein kann. Die Formgebung der Schalen 102, 104 ist derart, dass die Komponenten 106, 108 funktionssicher in einer ersten Betriebsposition gehalten werden, wobei notwendige Lüftungswege ebenfalls durch die Formgebung gebildet werden. Insbesondere ist lüfternah ein Lufteintritt 110 vorgesehen, weiterhin ein Luftaustritt 112 für vom Wärmetauscher 106 gekühlte Luft.

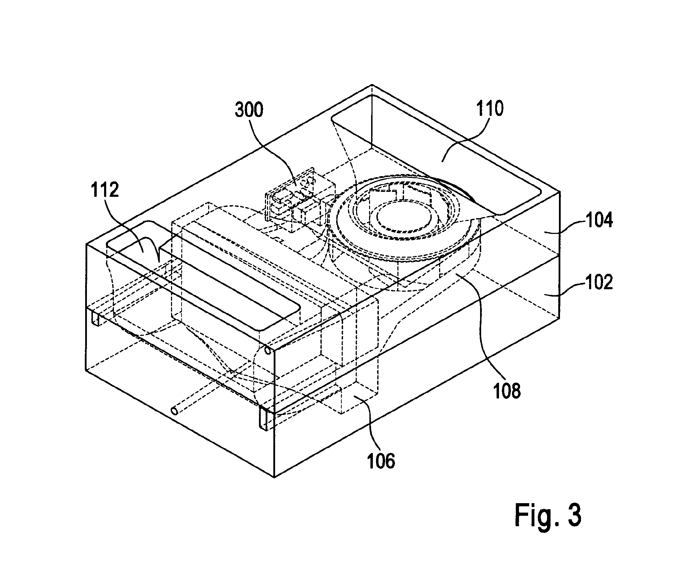

Die Anordnung der Komponenten innerhalb des Kühlmodulkörpers 102, 104 ist aus der perspektivischen Explosionsdarstellung gemäß Figur 3 erkennbar. Über den Lufteintritt 110 gelangt zu kühlende Luft zu einem Lüfter 108, der diese auf den Wärmetauscher 106 lenkt. Gekühlte Luft wird dann durch den Luftaustritt 112 aus dem Kühlmodulkörper 102, 104 ausgegeben. Für den Betrieb des Wärmetauschers 106 und des Lüfters 104 ist eine Steuerung 300 vorgesehen.

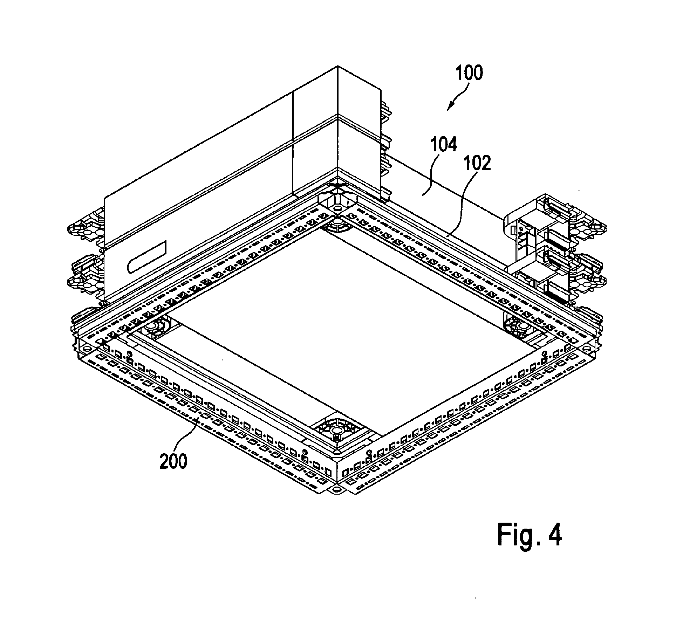

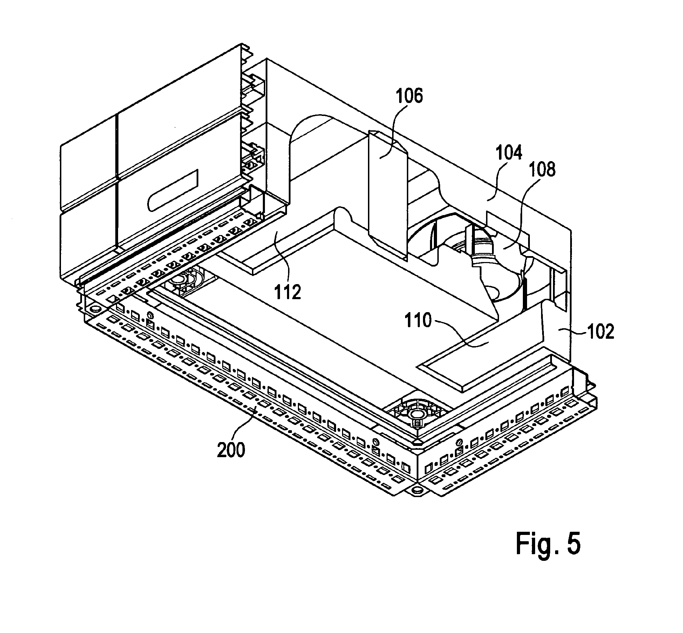

Figur 4 zeigt das Kühlmodul gemäß der vorliegenden Erfindung in Deckenmontage in einem Chassis 200. Hier ist der zweigeteilte Aufbau mit Schalen 102, 104 klar zu erkennen. Es wird deutlich, dass in dieser zweiten Betriebsposition die Lage des Kühlmoduls 100 gegenüber der Darstellung in Figur 1 um 180° gedreht ist, wobei die Drehung um eine Achse vorgenommen wurde, die in der Referenzebene A (Figur 2) liegt. Entsprechend zeigt die Figur 5 die reversierte Anordnung des Wärmetauschers 106 und des Lüfters 108, die auch in dieser zweiten Betriebsposition funktionssicher arbeiten. Der Lufteintritt 110 ist, ebenso wie der Luftaustritt 112, in der montierten Position nach unten gerichtet.

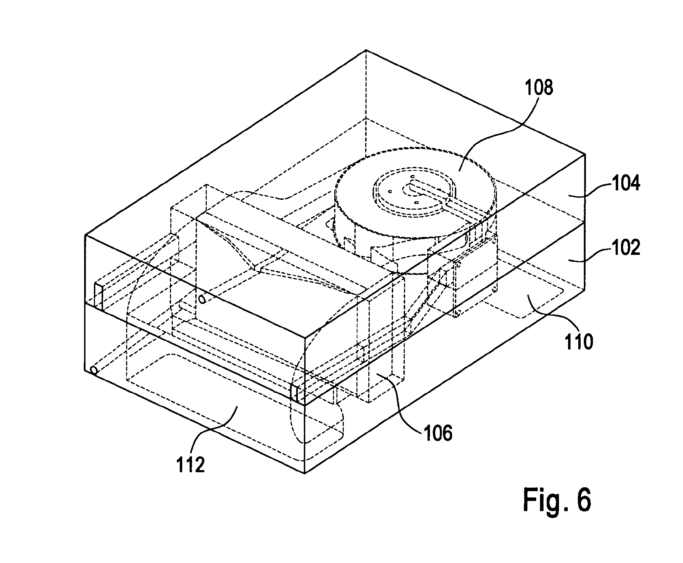

Figur 6 zeigt eine perspektivische Ansicht in Phantomdarstellung, die besonders deutlich die Reversierung gegenüber der Figur 3 darstellt. Die vom Lüfter 108 durch den Lufteintritt 110 angesaugte Luft wird durch den Wärmetauscher 106 gekühlt und tritt aus dem Luftaustritt 112 aus.

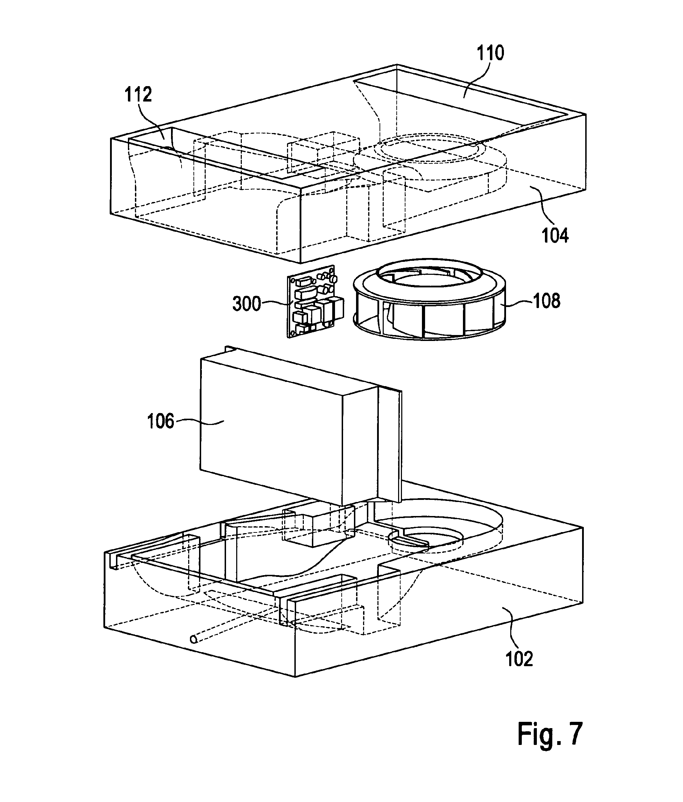

Figur 7 zeigt ein Kühlmodul gemäß der vorliegenden Erfindung in einer Explosionsdarstellung. Die Komponenten, wie Wärmetauscher 106, Lüfter 108 und Steuerung 300 werden in die Schale 102 eingesetzt und dort fest gehalten. Die Schale 104, die auf die Schale 102 aufzusetzen ist, enthält den Lufteintritt 110 und den Luftaustritt 112 und ist so geformt, dass sie die Komponenten 106, 108, 300 ebenfalls fest hält.

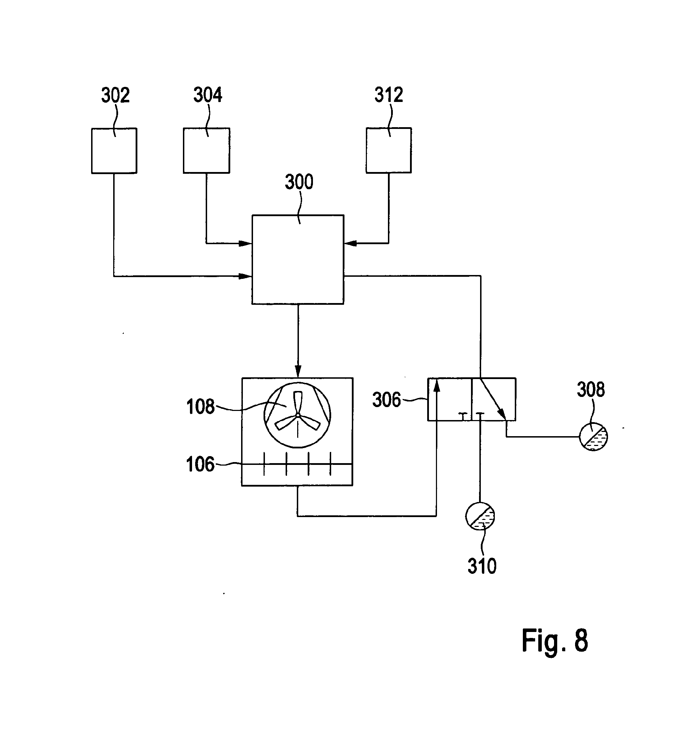

Figur 8 zeigt ein Beispiel eines Schaltdiagrammes, aus der die Funktionsweise der Steuerung 300 hervorgeht. An geeigneter Stelle angebrachte Sensoren, beispielsweise ein Temperatursensor 302 und ein Feuchtesensor 304 liefern Signale an die Steuerung 300, die diese entsprechend auswertet und den Lüfter 108 und den Wärmetauscher 106 entsprechend betreibt. Am Wärmetauscher 106 entstehendes Kondensat wird abgeleitet und gelangt zu einem Zwei-Wege-Ventil 306, in dem es wahlweise zu einem von zwei Kondensatabläufen 308, 310 geleitet werden kann. Die Auswahl erfolgt entsprechend der Betriebsposition, in der das Kühlmodul eingebaut werden soll. Grundsätzlich kann die Umstellung zwischen Kondensatablauf 308 und Kondensatablauf 310 manuell geschehen, einfach jedoch ist ein Lagesensor 312 vorgesehen, der die Einbauposition, also die erste oder die zweite Betriebsposition, erfasst und an die Steuerung 300 weitergibt, die dann das Zwei-Wege-Ventil 306 entsprechend ansteuert und den Weg zum Kondensatablauf 308 oder zum Kondensatablauf 310 freigibt. Die Kondensatabläufe sind dabei im Kühlmodulkörper entsprechend der benötigten Austrittsrichtung angeordnet.

Damit steht ein Kühlmodul zur Verfügung, dass ohne irgendwelche Umrüstungen in verschiedensten Einbausituationen einsetzbar ist, es müsste lediglich ein eventuell vorhandenes Display zur einwandfreien Lesbarkeit entsprechend der ersten oder zweiten Betriebsposition angeordnet werden.

Die in der vorstehenden Beschreibung, in der Zeichnung sowie in den Ansprüchen offenbarten Merkmale der Erfindung können sowohl einzeln als auch in beliebiger Kombination für die Verwirklichung der Erfindung wesentlich sein.

## Patentansprüche

1. Selbsttragendes Kühlmodul, bestehend aus
- einem selbsttragenden Kühlmodulkörper (102, 104), der aus geschäumtem Kunststoffmaterial aufgebaut ist, wobei in dem Kühlmodulkörper (102, 104) eine Referenzebene (A) definiert ist, in Bezug auf die in dem Kühlmodulkörper (102, 104) befindliche Komponenten in einer ersten Betriebsposition, in der alle Komponenten betriebsfähig zusammenwirken, angeordnet sind,
- einer Vielzahl von Komponenten (106, 108, 300), die zu kühlen sind oder die eine Kühlfunktion ausüben, wobei die Komponenten, die eine Kühlfunktion ausüben, zumindest einen Wärmetauscher (106) umfassen,
**dadurch gekennzeichnet, dass** die Komponenten (106, 108, 300) so in den Kühlmodulkörper (102, 104) eingelassen sind, dass sie auch in einer zweiten Betriebsposition, die gegenüber der ersten Betriebsposition um eine in der Referenzebene (A) liegende Achse um 180° gedreht ist, betriebsfähig zusammenwirken.

2. Selbsttragendes Kühlmodul nach Anspruch 1, **dadurch gekennzeichnet, dass** der Kühlmodulkörper (102, 104) zweischalig ausgebildet ist, wobei die Grenzfläche der zwei Schalen (102, 104) parallel zu oder in der Referenzebene (A) liegt.

3. Selbsttragendes Kühlmodul nach Anspruch 1, **dadurch gekennzeichnet, dass** der Wärmetauscher (106) einen Kondensatablauf (308, 310) aufweist, der in der ersten Betriebsposition Kondensat in einer ersten Richtung entlässt und der in der zweiten Betriebsposition Kondensat in einer zweiten Richtung entlässt.

4. Selbsttragendes Kühlmodul nach Anspruch 3, **dadurch gekennzeichnet, dass** der Kondensatablauf als Zwei-Wege-Ablauf (306, 308, 310), insbesondere als ventilgesteuerter Zwei-Wege-Ablauf ausgebildet ist.

5. Selbsttragendes Kühlmodul nach Anspruch 1, **dadurch gekennzeichnet, dass** eine Steuerung (300) vorgesehen ist, welche die eine Kühlfunktion ausübenden Komponenten (106, 108) abhängig von Signalen, die von mindestens einem Temperatursensor (302) und/oder von mindestens einem Feuchtesensor (304) an die Steuerung ausgegeben werden, betreibt.

6. Selbsttragendes Kühlmodul nach einem der Ansprüche 3 bis 5, **dadurch gekennzeichnet, dass** ein Lagesensor (312) vorgesehen ist, wobei die Steuerung (300) abhängig von den von dem Lagesensor (312) empfangenen Signalen das Ventil (306) des Zwei-Wege-Ablauf steuert, um das Kondensat entsprechend der erfassten Position des Kühlmodulkörpers (102, 104) in die erste Richtung oder in die zweite Richtung zu entlassen.

7. Selbsttragendes Kühlmodul nach Anspruch 1, **dadurch gekennzeichnet, dass** das Kunststoffmaterial expandiertes Polypropylen ist.

8. Selbsttragendes Kühlmodul nach Anspruch 2, **dadurch gekennzeichnet, dass** die Schalen (102, 104) des Kühlmodulkörpers in der montierten Position ineinander verrastet sind.
